# EUROPEAN PATENT APPLICATION

(11) **EP 2 312 621 A1**
(43) Date of publication of application: **20.04.2011**
(21) Application number: 10187339.6
(22) Date of filing: 12.10.2010
(51) Int. Cl.: H01L 21/336, H01L 29/417, H01L 29/78, H01L 29/10

(54) **MOS transistor including extended LDD source-drain regions**

(30) Priority: 13.10.2009 US 578539
(71) Applicant: Micrel, Inc., San Jose, CA 95131 (US)
(72) Inventor: Alter, Martin, Los Altos, CA 94022 (US)
(74) Representative: Powell, Stephen David

(57) **Abstract**

A MOS transistor includes a conductive gate insulated from a semiconductor layer by a dielectric layer, first and second lightly-doped diffusion regions formed self-aligned to respective first and second edges of the conductive gate, a first diffusion region formed self-aligned to a first spacer, a second diffusion region formed a first distance away from the edge of a second spacer, a first contact opening and metallization formed above the first diffusion region, and a second contact opening and metallization formed above the second diffusion region. The first lightly-doped diffusion region remains under the first spacer. The second lightly-doped diffusion region remains under the second spacer and extends over the first distance to the second diffusion region. The distance between the first edge of the conductive gate to the first contact opening is the same as the distance between the second edge of the conductive gate to the second contact opening.

## Description

### FIELD OF THE INVENTION

The invention relates to MOS transistors and, in particular, to a MOS transistor including an extended NLDD region at the drain and/or source terminal for improved ruggedness while maintaining the same gate to source contact and gate to drain contact distances as a normal non-extended LDD device.

### DESCRIPTION OF THE RELATED ART

In semiconductor transistor devices, "ruggedness" is a term that describes how much Energy (Joules) can be applied to a transistor device before the device is destroyed. Ruggedness is sometimes described in terms of a "SOA" or Safe Operating Area in that once the device is operating outside the boundary of current and voltage defined for a given device as the SOA curve, the operation is no longer "safe" and the device might be irreversibly damaged. It is desirable to make transistors more rugged while not compromising other manufacturing parameters, such as significantly increasing cost.

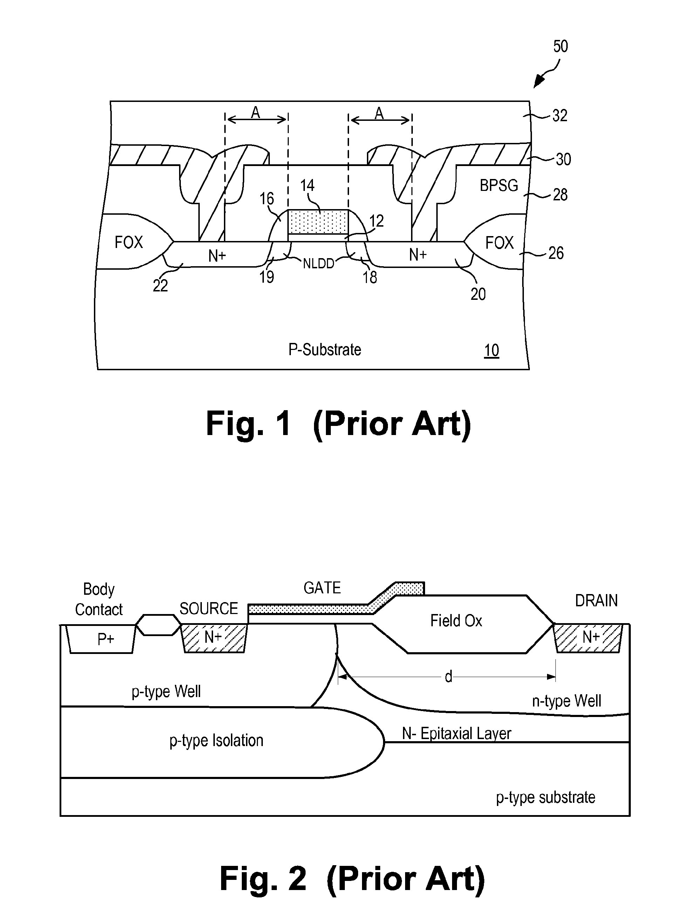

In submicron CMOS process technology, the lightly doped drain/source (LDD) is employed to connect the drain/source regions to the ends of the channel under the polysilicon gate, thereby reducing the electrical field at the drain of the transistor and minimizing impact ionization. As a result, impact ionization at the drain of the transistor is avoided. The LDD process involves using a moderate implant dose to form lightly doped source/drain regions self-aligned to the gate electrode, then forming spacers next to the gate electrode and finally forming heavily doped source/drain regions using a heavy implant self-aligned to the spacers. Figure 1 is a cross-sectional view of a conventional NMOS transistor including N-type LDD regions 18, 19 formed before spacer formation and heavily doped source/drain regions 20, 22 formed after spacers 16 are formed.

Impact ionization is particularly problematic for power transistors because of the high electric fields involved to obtain compact low ON resistance devices. To reduce impact ionization at the drain side for power transistors, the lateral double-diffused metal-oxide-semiconductor (LDMOS) transistors are sometimes used because of their high breakdown voltage characteristics. Figure 2 is a cross-sectional view of a conventional LDMOS transistor. In the LDMOS transistor, the heavily doped drain region is pulled back from the gate electrode and a lightly doped drift region formed by an N-Well, denoted by the distance "d", is used to spread the electric field out laterally to reduce impact ionization.

In the LDMOS transistor, when the drain region is pulled back, the contact to the drain region is also pulled back by the same amount so that the drain contact is formed over the N+ drain region. The LDMOS transistor is thus an asymmetric device with the gate to drain contact distance a lot larger than the gate to source contact distance. In some applications, the longer gate to drain contact distance is undesirable as it degrades the overall Ron*Area product (Power Density) of the N-channel power transistor. The term "Ron" refers to the series resistance of the transistor and "Area" refers to the area of the power transistor. When the distance between the gate and the drain contact increases, the Ron*Area product increases. The efficiency of the LDMOS transistor decreases as more power is dissipated over the long drift region.

### SUMMARY OF THE INVENTION

According to one embodiment of the present invention, a metal-oxide-silicon (MOS) transistor formed on a semiconductor layer of a first conductivity type including a conductive gate insulated from the semiconductor layer by a first dielectric layer; a first lightly-doped diffusion region of a second conductivity type being formed self-aligned to a first edge of the conductive gate; a second lightly-doped diffusion region of the second conductivity type being formed self-aligned to a second edge, opposite the first edge, of the conductive gate; a first diffusion region of the second conductivity type being formed over the first lightly-doped diffusion region where the first diffusion region is self-aligned to a first spacer formed on the sidewall of the first edge of the conductive gate and the first lightly-doped diffusion region remains under the first spacer; a second diffusion region of the second conductivity type being formed over the second lightly-doped diffusion region where the second diffusion region is formed a first distance away from the edge of a second spacer formed on the sidewall of the second edge of the conductive gate and the second lightly-doped diffusion region remains under the second spacer and extending over the first distance to the second diffusion region; a first contact opening formed above the first diffusion region and a first metallization formed in the first contact opening; and a second contact opening formed above the second diffusion region and a second metallization formed in the second contact opening. As thus formed, the distance between the first edge of the conductive gate to the first contact opening is the same as the distance between the second edge of the conductive gate to the second contact opening.

The second lightly-doped diffusion region forms an extended LDD region of the transistor. In one embodiment, the second lightly-doped diffusion region is a drain LDD region and the second diffusion region is a drain region. In another embodiment, the second lightly-doped diffusion region is a source LDD region and the second diffusion region is a source region.

According to another aspect of the present invention, a metal-oxide-silicon (MOS) transistor formed on a semiconductor layer of a first conductivity type including a conductive gate insulated from the semiconductor layer by a first dielectric layer; a first lightly-doped diffusion region of a second conductivity type being formed self-aligned to a first edge of the conductive gate; a second lightly-doped diffusion region of the second conductivity type being formed self-aligned to a second edge, opposite the first edge, of the conductive gate; a first diffusion region of the second conductivity type being formed over the first lightly-doped diffusion region where the first diffusion region is formed a first distance away from the edge of a first spacer formed on the sidewall of the first edge of the conductive gate and the first lightly-doped diffusion region remains under the first spacer and extending over the first distance to the first diffusion region; a second diffusion region of the second conductivity type being formed over the second lightly-doped diffusion region where the second diffusion region is formed the first distance away from the edge of a second spacer formed on the sidewall of the second edge of the conductive gate and the second lightly-doped diffusion region remains under the second spacer and extending over the first distance to the second diffusion region; a first contact opening formed above the first diffusion region and a first metallization formed in the first contact opening; and a second contact opening formed above the second diffusion region and a second metallization formed in the second contact opening. As thus formed, the distance between the first edge of the conductive gate to the first contact opening is the same as the distance between the second edge of the conductive gate to the second contact opening.

According to yet another aspect of the present invention, a method for forming a metal-oxide-silicon (MOS) transistor on a semiconductor layer of a first conductivity type includes forming a conductive gate being insulated from the semiconductor layer by a first dielectric layer; performing a first ion implantation step using a first mask to form a first lightly-doped diffusion region and a second lightly-doped diffusion region of a second conductivity type where the first lightly-doped diffusion region and second lightly-doped diffusion region are self-aligned to respective first and second edges of the conductive gate; forming spacers on the sidewalls of the conductive gate; performing a second ion implantation step using a second mask to form a first diffusion region and a second diffusion region of the second conductivity type where the second mask includes a pattern definition region for forming a resist portion overlapping the conductive gate and extending a first distance away from the edge of a second spacer formed on the sidewall of the second edge of the conductive gate and the first diffusion region is formed self aligned to a first spacer formed on the sidewall of the first edge of the conductive gate and the second diffusion region is formed self-aligned to the resist portion; forming a first contact opening above the first diffusion region and forming a first metallization in the first contact opening; and forming a second contact opening above the second diffusion region and forming a second metallization in the second contact opening. As thus constructed, the first lightly-doped diffusion region remains under the first spacer and the second lightly-doped diffusion region remains under the second spacer and extending over the first distance to the second diffusion region, the distance between the first edge of the conductive gate to the first contact opening is the same as the distance between the second edge of the conductive gate to the second contact opening.

According to another aspect of the present invention, a method for forming a metal-oxide-silicon (MOS) transistor on a semiconductor layer of a first conductivity type includes forming a conductive gate being insulated from the semiconductor layer by a first dielectric layer; performing a first ion implantation step using a first mask to form a first lightly-doped diffusion region and a second lightly-doped diffusion region of a second conductivity type where the first lightly-doped diffusion region and second lightly-doped diffusion region are self-aligned to respective first and second edges of the conductive gate; forming spacers on the sidewalls of the conductive gate; performing a second ion implantation step using a second mask to form a first diffusion region and a second diffusion region of the second conductivity type where the second mask including a pattern definition region for forming a first resist portion overlapping the conductive gate and extending a first distance away from the edge of a first spacer formed on the sidewall of the first edge of the conductive gate and a second resist portion overlapping the conductive gate and extending the first distance away from the edge of a second spacer formed on the sidewall of the second edge of the conductive gate and the first diffusion region is formed self aligned to the first resist portion and the second diffusion region is formed self-aligned to the second resist portion; forming a first contact opening above the first diffusion region and forming a first metallization in the first contact opening; and forming a second contact opening above the second diffusion region and forming a second metallization in the second contact opening. As thus constructed, the first lightly-doped diffusion region remains under the first spacer and the second lightly-doped diffusion region remains under the second spacer and extending over the first distance to the second diffusion region. The distance between the first edge of the conductive gate to the first contact opening is the same as the distance between the second edge of the conductive gate to the second contact opening.

The present invention is better understood upon consideration of the detailed description below and the accompanying drawings.

### BRIEF DESCRIPTION OF THE DRAWINGS

Figure 1 is a cross-sectional view of a conventional NMOS transistor.

Figure 2 is a cross-sectional view of a conventional LDMOS transistor.

Figure 3 is a cross-sectional view of an NMOS transistor according to one embodiment of the present invention at an intermediate step of the fabrication process.

Figure 4 is a cross-sectional view of an NMOS transistor according to one embodiment of the present invention.

Figure 5 is a cross-sectional view of an N-type LDMOS transistor according to one embodiment of the present invention.

Figure 6 is a cross-sectional view of an NMOS transistor according to a second embodiment of the present invention.

Figure 7 is a cross-sectional view of an NMOS transistor according to a third embodiment of the present invention.

### DETAILED DESCRIPTION OF THE PREFERRED EMBODIMENTS

In accordance with the principles of the present invention, an NMOS (N-type metal-oxide-silicon) transistor includes an extended NLDD region at the drain for improved ruggedness while maintaining the same gate to source contact and gate to drain contact distances. In this manner, impact ionization at the drain of the transistor is reduced while the overall ruggedness of the transistor is improved without substantially degrading the Ron*Area product. In other embodiments, a PMOS transistor including an extended NLDD region at the drain is provided to increase the breakdown voltage of the PMOS transistor.

The NMOS transistor structure of the present invention is particularly applicable for power transistors but can also be used in non-power applications. The NMOS transistor of the present invention includes an extended NLDD region at the drain and therefore differs from the conventional NMOS transistor in that the drain and source diffusion regions are not symmetrical. The electrical characteristics of the NMOS transistor of the present invention will therefore be slightly different from that of a conventional NMOS transistor with symmetrical drain/source diffusion.

According to another aspect of the present invention, a MOS (metal-oxide-silicon) transistor includes an extended NLDD region at the source and/or the drain for improved ruggedness while maintaining the same gate to source contact and gate to drain contact distances as a normal non-extended LDD device. In this manner, impact ionization at the source and drain of the transistor is reduced while the overall ruggedness of the transistor is improved without substantially degrading the Ron*Area product.

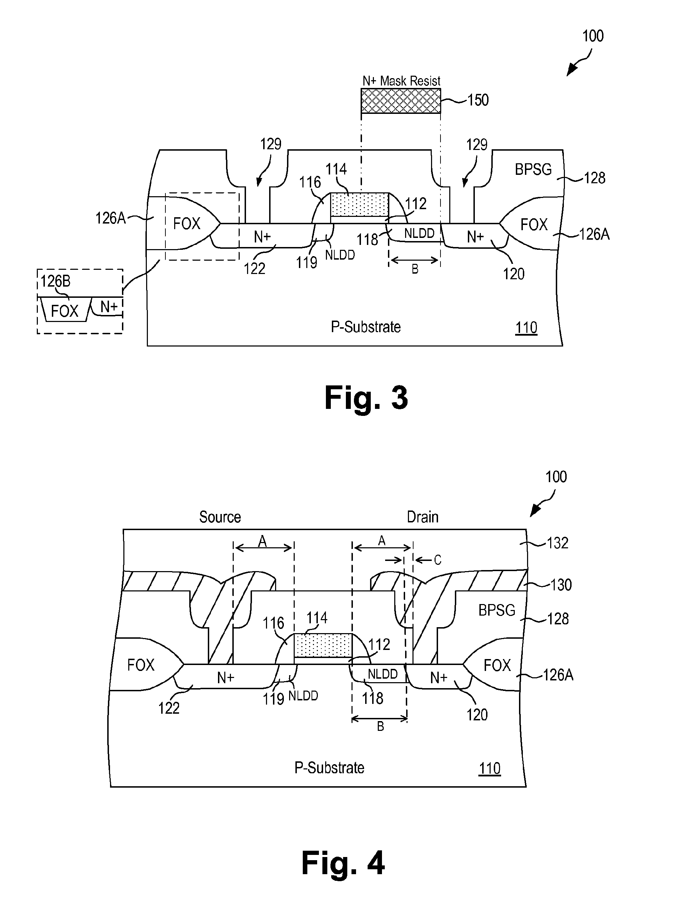

Figure 3 is a cross-sectional view of an NMOS transistor according to one embodiment of the present invention at an intermediate step of the fabrication process. Figure 4 is a cross-sectional view of an NMOS transistor according to one embodiment of the present invention. Referring to Figures 3 and 4, in the present embodiment, NMOS transistor 100 is formed on a P-type semiconductor layer 110 being a P-type substrate. In other embodiments, semiconductor layer 110 can include an epitaxial layer, buried layer formed on the P-type substrate or other substrate structure commonly used or to be developed. Furthermore, in other embodiments, NMOS transistor 100 can be formed in a P-well formed in P-type substrate 110. The exact nature and construction of semiconductor layer 110 is not critical to the practice of the present invention.

The next step in the fabrication process of NMOS transistor 100 involves forming a field oxide layer 126A defining the active area on substrate 110 in which the transistor is to be formed. In Figure 3, an isoplanar process is shown and the field oxide layer 126A is formed partially above the silicon substrate surface. In other fabrication processes, such as the shallow trench isolation process (STI), the field oxide layer 126B is formed coplanar to the silicon substrate surface, as shown in the insert in Figure 3. Then, a gate oxide layer 112 is grown and a polysilicon layer 114 is deposited and patterned to form the gate electrode. A first N-type implantation is carried out using a first N-type mask to form lightly doped drain/source (LDD) regions 118 and 119. The first N-type mask exposes the active areas on substrate 110 and the LDD regions are therefore formed using the gate electrode as a mask. The LDD regions 118 and 119 are self-aligned to the edges of the polysilicon gate electrode 114.

After the LDD regions 118 and 119 are formed, a dielectric layer is conformally deposited and anisotropically etched to form spacers 116 along the sidewalls of gate electrode 114. In conventional processes, such as NMOS transistor 50 of Figure 1, spacers 16 define the locations of the heavily doped N+ source/drain regions relative to the gate electrode. That is, a second N-type implantation is carried out using the same first N-type mask which covers the P-type regions on the substrate which are not to receive the N-type implantation. In the exposed N-type regions, the gate electrode and the spacers act as masks to form self-aligned N+ source and drain regions 20, 22. The N+ source/drain regions in the conventional NMOS transistor 50 are formed in the active areas defined by the field oxide 26 and are self-aligned to the edges of the spacers 16.

However, in accordance with the present invention, a second N-type mask for N-type implants is used for the second N-type implantation step where the second N-type mask is similar to the first N-type mask but also includes an additional pattern definition region, referred herein as the "N+ pull-back region," for forming a resist portion 150 in the N-type drain regions.
The resist portion 150 overlaps partially the gate electrode and extends to cover an area over the NLDD region adjacent the gate electrode on the drain side. The second N-type implantation step is carried out using the resist pattern defined by the second N-type mask, including the resist portion 150, and the spacers and the gate electrode as a mask. The N+ source region 122 thus formed is self-aligned to the spacer 116 while the N+ drain region 120 thus formed is self-aligned to the edge of the resist portion 150. As a result, the N+ drain region is pulled back from the edge of the gate electrode. A mini-drift region, defined by the length "B" is thus formed by the NLDD region 118 connecting the N+ drain to the channel region of NMOS transistor 100.

After the N+ drain/source regions 120, 122 are formed a dielectric layer 128, typically a BPSG layer, is deposited and patterned to make contact holes 129 to the N+ drain/source regions. In accordance with the present invention, the contact hole 129 to the N+ drain region 120 is formed using the same gate-to-contact spacing as the contact hole 129 to the N+ source region 122. That is, even when the N+ drain region 120 has been pulled back from the gate electrode, the gate to drain contact spacing is not increased but rather remain the same as the gate to source contact spacing. The N+ drain region 120 is pulled back by a distance B from the gate electrode but enough N+ drain region is left to overlap the contact hole 129 to ensure a proper ohmic contact.

Referring now to Figure 4, a metal layer 130 is deposited and patterned to form metal interconnects between devices formed on substrate 110. Metal layer 130 is formed in contact holes 129 to form ohmic contacts with the N+ source and drain regions 122, 120. Another dielectric layer 132, such as an oxide or a silicon nitride layer, is deposited on top of the metal layer to insulate metal layer 130. NMOS transistor may be subjected to subsequent processing steps, such as for forming additional metal layers for interconnections and additional dielectric layers for insulation and passivation. The subsequent processing steps are not critical to the practice of the present invention.

In one embodiment, NMOS transistor 100 is fabricated using a 0.5 micron technology which defines a gate to contact spacing of 0.4 µm. An N+ pull back distance B of 0.3 µm is used leaving a 0.1 µm contact to N+ overlap ("C"). Other values of N+ pull back distance can be used as long as there is 0 or greater amount of contact to N+ overlap. In one embodiment, the N+ pull back distance is between 0.15µm to 0.35µm. Furthermore, the N+ pull back distance can be as high as 0.4µm where the edge of the N+ drain region aligns with the contact.

It is instructive to note that the total gate electrode to drain contact spacing "A" has not increased even when the N+ region has been pulled back from the gate electrode. The gate to drain contact spacing A remains 0.4 µm. Furthermore, the gate to drain contact spacing remains the same as the gate to source contact spacing. With a 0.3 µm N+ drain pull back, a 2% increase in Ron is observed as the drain region is now formed with a larger portion of NLDD region than at the source side. However, for only a 2% increase in Ron, additional SOA voltage of 0.5V can be achieved before the NMOS transistor I-V characteristics snapback.

An important feature of the NMOS transistor of the present invention is that no additional masking step is required to realize the pull back on the N+ drain region. The NMOS transistor of the present invention requires only a modification to the N-type mask to add the N+ pull back region. The N+ pull back region in the second N-type mask blocks the N+ implants adjacent the gate electrode on the drain side in order to pull back the N+ drain region.

In conventional CMOS fabrication process, the N-type mask is usually used for both the NLDD implant step and also the N+ source/drain implant step. At the NLDD implant step, the NLDD implants are self-aligned to the edge of the gate electrode. At the N+ source/drain implant step, the N+ implants are self-aligned to the edge of the spacers. However, in accordance with the present invention, a first N-type mask is used for the NLDD implant and a second N-type mask is used for the N+ source/drain implant. The second N-type mask includes the N+ pull back region definition to allow the formation of resist portions that blocks the N+ implants near the gate electrode on the drain side. Although a separate second mask is required to realize the N+ pull back, there is no additional masking step involved as the fabrication process does not change. The additional cost of a second N-type mask is insignificant for achieving the ruggedness improvement in the NMOS transistor.

In the present embodiment, the N+ pull back region is drawn in the second N-type mask by aligned it to the middle of the gate electrode. Accordingly, even with the most extreme case of misalignment, the N+ pull back region is assured not to crossover to the source side to affect the source region.

As thus formed, NMOS transistor 100 has an increased drain to gate resistance because of the longer NLDD region between the N+ drain region 120 and the channel under the gate electrode. However, the degradation in series resistance is compensated by an increase in ruggedness of the transistor device. In one embodiment of the present invention, the series resistance is increased by 5% as compared to conventional case while the tolerance for electrode static discharge (ESD) is significantly improved. In one embodiment, a 200% increase in the Human Body Model ESD performance is observed and a greater than 33% increase in the Machine Model ESD performance is observed.

It is important to note that the NMOS transistor of the present invention is distinguishable from an LDMOS transistor which has an extended drift region at the drain. In LDMOS transistors, the gate to drain contact spacing is extended to accommodate an extended drift region. The gate to drain contact spacing in an LDMOS transistor is much greater than the gate to source contact spacing. The LDMOS transistor device is not symmetrical and thus has a greater cell pitch. In the NMOS transistor of the present invention, the NMOS transistor is symmetrical and the N+ drain region is pull back to form a mini-drift region. However, the cell pitch of the NMOS transistor of the present invention is unchanged from a conventional NMOS transistor because the transistor cell structure remains symmetrical with the same poly to contact spacing at both the source and drain sides.

In the above description, an NMOS transistor with an extended NLDD region is described. In other embodiments, the fabrication method of the present invention for forming an extended NLDD region can be applied to a PMOS transistor for forming an extended PLDD region at the drain of the PMOS transistor. While PMOS transistors do not suffer from the hot electron/impact ionization issues as NMOS transistors, the extended PLDD region can increase the breakdown voltage of the PMOS transistors, thereby improving the ruggedness of the PMOS transistors.

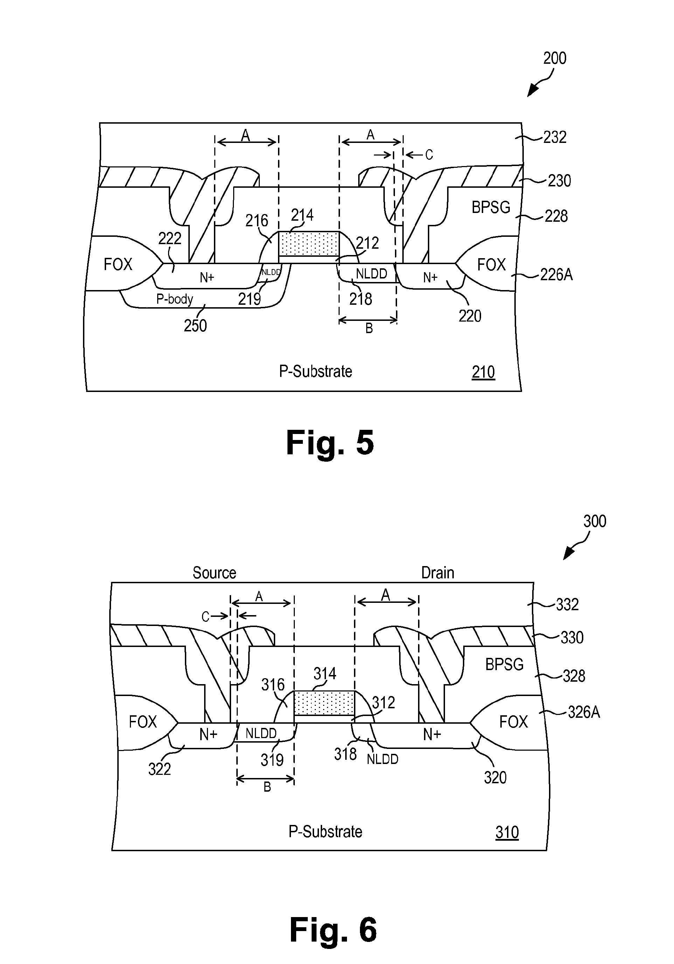

Furthermore, the NMOS transistor with an extended NLDD region can also be applied to form an N-channel LDMOS transistor including a p-type body as the drift region. Figure 5 is a cross-sectional view of an N-type LDMOS transistor according to one embodiment of the present invention. Referring to Figure 5, LDMOS transistor 200 includes a P-type body region 250 in which the N+ source 222 and the NLDD region 219 are formed. Otherwise, LDMOS transistor 200 has a similar structure as NMOS transistor 100 of Figure 4. More specifically, the LDMOS transistor 200 of Figure 5 includes an extended NLDD region which is formed in the same manner as the extended NLDD region of NMOS transistor 100 of Figure 4. The extended NLDD region of LDMOS transistor 200 improves the overall ruggedness of the LDMOS transistor by reducing impact ionization at the drain of the transistor.

In the above described embodiments, the extended LDD region is described as being applied to the drain region of the MOS transistor. It is understood by one skilled in the art that the source/drain regions of a MOS transistor is operationally interchangeable and the source/drain regions are usually named according to the bias voltage condition. According to another aspect of the present invention, the extended LDD region is applied to the source region of the MOS transistor. Figure 6 is a cross-sectional view of an NMOS transistor according to a second embodiment of the present invention. NMOS transistor 300 of Figure 6 is constructed in substantially the same manner as NMOS transistor 100 of Figure 4 an like elements are given like reference numerals to simplify the discussion. Referring to Figure 6, NMOS transistor 300 includes an extended NLDD region 319 at the source of the transistor. In this embodiment, the drain is formed with an NLDD region 318 that is not pulled back from the edge of the gate electrode. The gate-to-source contact spacing "A" has not increased even when the N+ source diffusion region has been pulled back from the gate electrode. That is, the gate-to-source contact spacing is the same as the gate-to-drain contact spacing and is the same spacing as a normal non-extended LDD device.

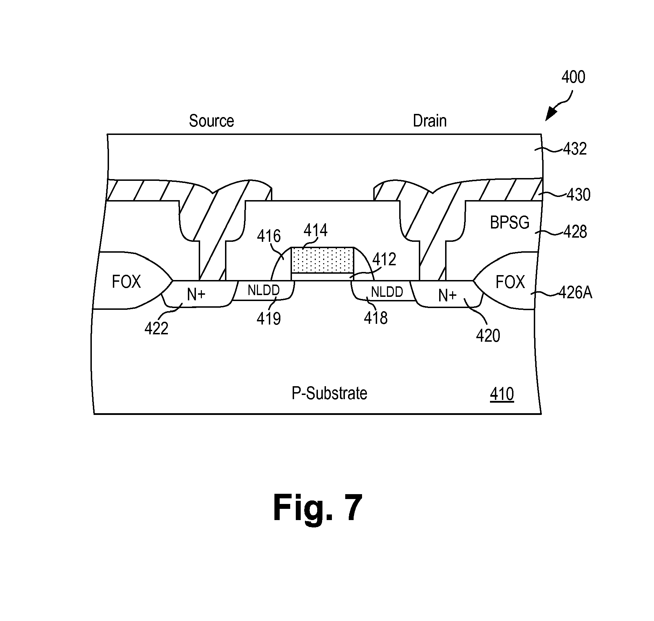

According to yet another embodiment of the present invention, both the source and the drain are formed using extended LDD regions. Figure 7 is a cross-sectional view of an NMOS transistor according to a third embodiment of the present invention. NMOS transistor 400 of Figure 7 is constructed in substantially the same manner as NMOS transistor 100 of Figure 4 an like elements are given like reference numerals to simplify the discussion. Referring to Figure 7, NMOS transistor 400 includes an extended NLDD region 418 at the drain and an extended NLDD region 419 at the source. The gate-to-source contact spacing and the gate-to-drain contact spacing have not increased even when the N+ source/drain diffusion regions have been pulled back from the gate electrode. As thus configured, impact ionization at the source and drain of the transistor is reduced to improve ruddgedness while the Ron*Area product is not degraded. More specifically, the gate-to-source contact spacing is the same as the gate-to-drain contact spacing and both are the same spacing as a normal non-extended LDD device.

The above detailed descriptions are provided to illustrate specific embodiments of the present invention and are not intended to be limiting. Numerous modifications and variations within the scope of the present invention are possible. The present invention is defined by the appended claims.

## Claims

1. A metal-oxide-silicon (MOS) transistor formed on a semiconductor layer of a first conductivity type, comprising:
a conductive gate insulated from the semiconductor layer by a first dielectric layer;
a first lightly-doped diffusion region of a second conductivity type being formed self-aligned to a first edge of the conductive gate;
a second lightly-doped diffusion region of the second conductivity type being formed self-aligned to a second edge, opposite the first edge, of the conductive gate;
a first diffusion region of the second conductivity type being formed over the first lightly-doped diffusion region;
a second diffusion region of the second conductivity type being formed over the second lightly-doped diffusion region, the second diffusion region being formed a first distance away from the edge of a second spacer formed on the sidewall of the second edge of the conductive gate, the second lightly-doped diffusion region remaining under the second spacer and extending over the first distance to the second diffusion region;
a first contact opening formed above the first diffusion region and a first metallization formed in the first contact opening; and
a second contact opening formed above the second diffusion region and a second metallization formed in the second contact opening,
wherein the distance between the first edge of the conductive gate to the first contact opening is the same as the distance between the second edge of the conductive gate to the second contact opening.

2. The MOS transistor of claim 1, wherein the first conductivity type is P-type and the second conductivity type is N-type, the MOS transistor comprises an NMOS transistor.

3. The MOS transistor of claim 1, wherein the first conductivity type is N-type and the second conductivity type is P-type, the MOS transistor comprises a PMOS transistor.

4. The MOS transistor of claim 1, wherein the first lightly-doped diffusion region comprises a lightly-doped drain region, the first diffusion region comprises a drain region, the second light-doped diffusion region comprises a lightly-doped source region, and the second diffusion region comprises a source region.

5. The MOS transistor of claim 1, wherein the first lightly-doped diffusion region comprises a lightly-doped source region, the first diffusion region comprises a source region, the second light-doped diffusion region comprises a lightly-doped drain region, and the second diffusion region comprises a drain region, the MOS transistor further comprising:
a body region of the first conductivity type in which the lightly-doped source region and the source region are formed, wherein the MOS transistor comprises a LDMOS transistor.

6. The MOS transistor of claim 1, wherein the first diffusion region is self-aligned to a first spacer formed on the sidewall of the first edge of the conductive gate, the first lightly-doped diffusion region remaining under the first spacer.

7. The MOS transistor of claim 1, wherein the first diffusion region is formed a first distance away from the edge of a first spacer formed on the sidewall of the first edge of the conductive gate, the first lightly-doped diffusion region remaining under the first spacer and extending over the first distance to the first diffusion region,
wherein the distance between the first edge of the conductive gate to the first contact opening is the same as the distance between the second edge of the conductive gate to the second contact opening and is the same as the gate-to-contact distance in a conventional light-doped drain device.

8. The MOS transistor of claim 1, wherein the distance between the second edge of the conductive gate to the drain contact opening is Nµm and the first distance comprises a value between 0.3µm to Nµm.

9. A method for forming a metal-oxide-silicon (MOS) transistor on a semiconductor layer of a first conductivity type, comprising:
forming a conductive gate being insulated from the semiconductor layer by a first dielectric layer;
performing a first ion implantation step using a first mask to form a first lightly-doped diffusion region and a second lightly-doped diffusion region of a second conductivity type, the first lightly-doped diffusion region and second lightly-doped diffusion region being self-aligned to respective first and second edges of the conductive gate;
forming spacers on the sidewalls of the conductive gate;
performing a second ion implantation step using a second mask to form a first diffusion region and a second diffusion region of the second conductivity type, the second mask including a pattern definition region for forming at least a first resist portion overlapping the conductive gate and extending a first distance away from the edge of a first spacer formed on the sidewall of the first edge of the conductive gate, the first diffusion region being formed self-aligned to the resist portion;
forming a first contact opening above the first diffusion region and forming a first metallization in the first contact opening; and
forming a second contact opening above the second diffusion region and forming a second metallization in the second contact opening,
wherein the first lightly-doped diffusion region remains under the first spacer and extending over the first distance to the first diffusion region and the second lightly-doped diffusion region remains under a second spacer formed on the sidewall of the second edge of the conductive gate, the distance between the first edge of the conductive gate to the first contact opening is the same as the distance between the second edge of the conductive gate to the second contact opening.

10. The method of claim 9, wherein the first conductivity type is P-type and the second conductivity type is N-type, the MOS transistor comprises an NMOS transistor.

11. The method of claim 9, wherein the first conductivity type is N-type and the second conductivity type is P-type, the MOS transistor comprises a PMOS transistor.

12. The method of claim 9, wherein the first lightly-doped diffusion region comprises a lightly-doped source region, the first diffusion region comprises a source region, the second light-doped diffusion region comprises a lightly-doped drain region, and the second diffusion region comprises a drain region.

13. The method of claim 9, wherein the resist portion overlaps the conductive gate by about 50%.

14. The method of claim 9, wherein the second diffusion region is formed self-aligned to the first spacer.

15. The method of claim 9, wherein the step of performing a second ion implantation step comprises
performing a second ion implantation step using a second mask to form a first diffusion region and a second diffusion region of the second conductivity type, the second mask including a pattern definition region for forming a first resist portion overlapping the conductive gate and extending a first distance away from the edge of the first spacer formed on the sidewall of the first edge of the conductive gate and a second resist portion overlapping the conductive gate and extending the first distance away from the edge of the second spacer formed on the sidewall of the second edge of the conductive gate, the first diffusion region being formed self-aligned to the first resist portion and the second diffusion region being formed self-aligned to the second resist portion;
wherein the distance between the first edge of the conductive gate to the first contact opening is the same as the distance between the second edge of the conductive gate to the second contact opening and is the same as the gate-to-contact distance in a conventional light-doped drain device.
